# EUROPEAN PATENT SPECIFICATION

(11) **EP 1 934 003 B1**
(45) Date of publication and mention of the grant of the patent: **05.11.2014**
(21) Application number: 06793736.7
(22) Date of filing: 22.09.2006
(51) Int. Cl.: B22D 11/04

(54) **INGOT MOLD FOR CASTING SLABS**
KOKILLE ZUM BRAMMENGIESSEN
LINGOTIERE DE COULEE DE BRAMES

(30) Priority: 22.09.2005 IT MI20051765
(43) Date of publication of application: 25.06.2008
(73) Proprietor: DANIELI & C. OFFICINE MECCANICHE S.p.A., 35042 Buttrio (IT)
(72) Inventor: BENEDETTI, Gianpietro, I-33019 Tricesimo (IT); KAPAJ, Nuredin, I-33100 Udine (IT); POLONI, Alfredo, I-34070 Fogliano Redipuglia (IT)
(74) Representative: Cinquantini, Bruno
(86) International application number: PCT/EP2006/066616
(87) International publication number: WO 2007/039484

(56) References cited:
- EP-A- 0 909 597
- DE-A1- 3 907 351
- US-A- 5 460 220

## Description

### Scope of invention

The present invention relates to an ingot mold for casting ultra thin slabs to be used, for instance, in a manufacturing plant for the manufacture of metal strips.

### State of the art

Numerous types of ingot molds used for casting metal strips, in particular steel, are known in the state of the art. These ingot molds can produce a slab which is subjected to a number of thickness reductions, sometimes associated with surface treatments and machining, depending on the various processes used. Example of ingot molds for casting of thin slabs are disclosed in US 5460220, EP 0909597 and DE 3907351. Since the thickness of the slab coming out of the ingot mold is considerable, in comparison to the final thickness to be achieved at the end of the production line, numerous rolling cages are required. Since the passage through every cage involves cooling down the strip, after the passage through some rolling cages, an induction furnace or heating furnace for heating the strip is required for bringing its temperature back to the value necessary for rolling the material properly.

Yet, by doing so, the metal strip machinery will be particularly long because the slabs produced by the ingot molds, of the known type, also called crystallizers, have considerable thicknesses when coming out of the ingot mold, hence they will require numerous intermediate devices which will increase the total length of the machinery to a great extent.

Great efforts have been made to achieve ingot molds able to produce thinner slabs so as to use, along the production line of the strip, less rolling cages to reduce the thickness, thus with the advantage of reducing the total length of the line and to reduce the energy costs for producing the strip.

Currently, with strip manufacturing machinery of the known type, the minimum producible thickness value of a slab coming out of the ingot mold, when using very performing devices, is between 50 and 60 mm. As a result, lower thickness values involve a series of problems which are hardly possible to solve; the main problems are described as follows:
- there is insufficient space for the submerged discharge device, thus its small distance from the wide plates of the crystallizer produces solidification bridges; furthermore, it is necessary to reduce the thickness of refractory material of the discharge device, hence negatively affecting its duration;
- there is too small a surface at the meniscus to effectively melt the lubrication powders, hence resulting in evident critical conditions, especially at high casting speed;
- it is difficult to achieve a slab coming out of the ingot mold which still has an adequate length of the liquid core and be able to carry out a soft-reduction on the slab, which is necessary to improve its internal quality;
- the fluid mechanics inside the crystallizer is-not optimal inasmuch as a reduced volume of molten steel, resulting from the reduced thickness, does not allow good turbulence damping which can cause an unstable meniscus, hence with unwanted incorporation of the lubrication powders, which could also cause remelting phenomena of the solidified skin which will negatively affect the quality of the end product achieved.

Document US5460220 describes, for example, an ingot mold for the production of cross-sectional slabs used particularly for a "soft reduction" treatment which helps improve the structural qualities of the strip. Such ingot mold, however, is able to produce slabs with a thickness that still requires considerably large machinery for the production line.

Furthermore the configuration and the dimensions of the basin of this ingot mold are not sufficient to prevent the molten steel jets of the discharge device from causing an unwanted remelting phenomenon of the skin formed on the surface of the basin thereof, resulting from the high turbulence which is produced in the ingot mold feeding zone.

Finally, with this ingot mold, it is not possible to operate at adequately high casting speeds, hence it does not allow the possibility to receive high rates of molten steel from the discharge device without producing flaws.

Thus, it is necessary to achieve an ingot mold to cast slabs to overcome the foregoing drawbacks.

### Summary of the invention

One main purpose of the present invention is to achieve an ingot mold for casting ultra thin slabs to be used, for instance, in a manufacturing plant for the manufacture of metal strips, in particular steel strips. Another purpose of the ingot mold, according to the invention, is to produce strips with thin thicknesses, about 20 mm, at high casting speeds and able to reach 16 m/min, thereby achieving a slab with good internal quality.

Advantageously, a more accentuated convex shape of the parts of the basin or casting chamber of the ingot mold, according to the invention, ensures enough space to prevent the molten steel jets of the discharge device from causing an unwanted remelting phenomenon of the skin formed around its internal surface, especially starting at a certain distance from the discharge device, which is the biggest area of the jet section. As a result, it is possible to get a better discharge flow in the feeding zone of the ingot mold where the discharge device of molten steel is placed, in addition to less turbulence.

Therefore, the present invention intends to solve the above-mentioned problems by achieving an ingot mold for casting ultra thin (20 - 50 mm) steel slabs, with casting speed between 6 and 16 m/min, thus defining a longitudinal plane of symmetry and a cross-sectional plane of symmetry, reciprocally orthogonal, comprising a passing cavity with an entrance section and an exit section of the steel, the cavity surface consisting of two first walls - arranged reciprocally facing two opposite sides of the longitudinal plane of symmetry and two second narrow, flat and rectangular walls parallel to the cross-sectional plane of symmetry, wherein the first and second walls form four longitudinal corners in the reciprocal connecting areas and where the first walls have a concave central area, with concavity facing the longitudinal plane of symmetry, straight portions of the wall relative to its ends and intermediate convex connecting portions, with convexity facing the longitudinal plane of symmetry, wherein the connecting portions and the concave central area determine inflection points in the reciprocal connecting points and in which the straight portions of the wall and the connecting portions determine connecting points in the reciprocal junction points wherein the ratio between the length d/l is between 10 and 60% and the ratio h/f is between 10% and 60% wherein
- "d" is the length of the connecting portion measured in projection view on the longitudinal plane of symmetry,
- length "l" is the distance between the two symmetrical connecting points relative to the cross-sectional plane of symmetry, measured in projection view on the plane of symmetry (X),
- "h": is the distance between the connecting point P and the inflection point P' measured in projection view on the cross-sectional plane of symmetry Y;
- "f" is the distance between point P' and the tangent to the concave area in the maximum point of concavity measured in projection view on the plane of symmetry Y.

According to the invention, by using the ingot mold it is possible to cast a slab with a thickness much smaller than the thickness that can be achieved with known ingot molds, between 20-50mm, yet helping maintain a certain length of liquid core downstream of the exit section of the ingot mold, and wherein the core remains liquid even in the zones nearest the furthermost side parts. Hence, when the slab is subjected to the liquid core pre-rolling, it will be possible to obtain a refinement of the internal structure by reducing the central porosity as well as the segregation.

Thus the possibility to cast ultra thin slabs of the above-mentioned dimensions makes it possible to achieve metal strip machinery with a reduced height and length compared to the machinery known in the art.

Moreover, it is necessary to point out an additional advantage: the strip obtained at the end of the passage throughout the whole hot-rolling and casting line is already at its final thickness and ready to be used, without the need to carry out an additional treatment in a cold-rolling line.

The dependent claims describe preferred embodiments of the invention.

### Brief description of the Figures

Further features and advantages of the invention will become apparent by means of the detailed description of preferred embodiments, given by way of not limitative examples of an ingot mold, illustrated with the aid of the following figures wherein:
Fig. 1 shows a three-dimensional view of the ingot mold of the invention;
Fig. 2a shows a section along plane y-z of the ingot mold of Fig. 1;
Fig. 2b shows a plane view of the ingot mold of Fig. 1;
Fig. 3a shows a section along plane y-z of another embodiment of the ingot mold of the invention;
Fig. 3b shows a plane view of the embodiment of Fig. 3a;
Fig. 4 shows a semi-section view along a plane parallel to the reference axes x-y of the ingot mold in Fig. 1.

### Detailed description of preferred embodiments of the invention

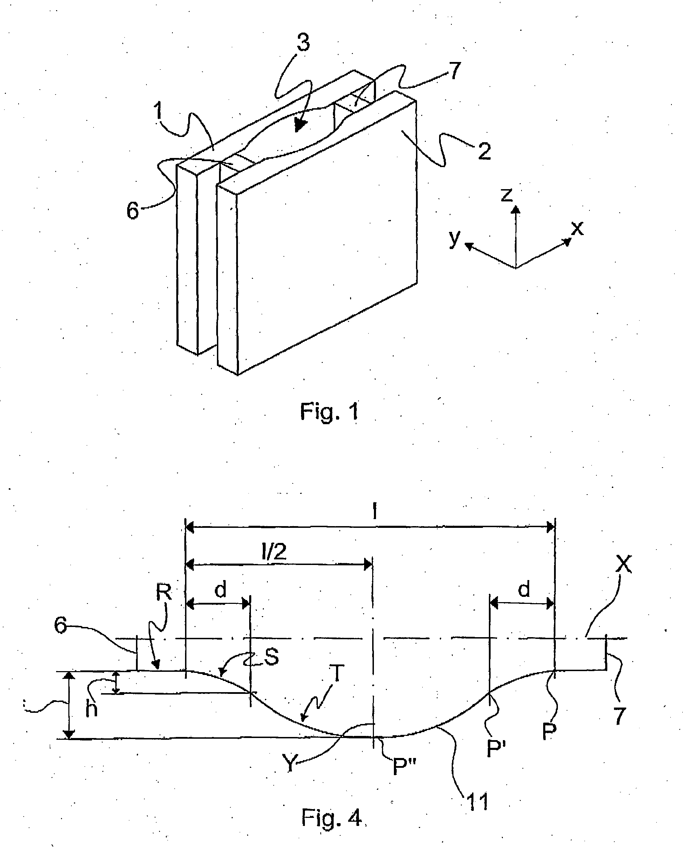

With reference to Figure 1, where an orthogonal reference axis system is defined, x, y, z, there is a representation of an ingot mold - with a longitudinal plane of symmetry X parallel to the axes of reference x-z, and a cross-sectional plane of symmetry Y parallel to the reference axes y-z - comprising two wide plates 1, 2 which, when coupled together with two interposing elements or narrow walls 6, 7, determine a through cavity 3 or basin or casting chamber 3.

The surface of said cavity is determined by two wide walls 4, 5, reciprocally arranged and facing out on opposite sides relative to the plane of symmetry x-z, and by narrow walls 6, 7, arranged at a right angle relative to the plane of symmetry Y. The walls 4, 5, 6, 7 form four longitudinal corners in their connecting zones.

The wide walls 4, 5 of the plates 1, 2 have a double curvature. One is concave whereas the other is convex and faces the longitudinal plane of symmetry X. Advantageously, considering a section which is transversal and perpendicular to plane X as described in Fig. 4, each of the wide walls 4, 5 comprises:
- a concave central area 11, with concavity facing the longitudinal plane of symmetry X, in the shape of a semi-circular arc,
- two flat lateral zones 12, parallel to the plane of symmetry X, each of which located near one end of the concave central area 11,
- two connecting zones 13, with a convex surface, between the semi-circular arc of the central zone 11 and the lateral zones 12, with convexity facing the plane of symmetry X.

With reference to the left side of the semi-section view, the following references are given in Fig. 4:
- P is the intersection point of the rectilinear portion R of the flat zone of the walls with convex connecting portion S;
- P' is the point in which the concavity of the wide plate 2, also called inflection point, changes;
- point P" is the intersection point of the concave area 11 with the cross-sectional plane of symmetry Y parallel to the reference axes y and z.

At this point, the following values are given:
- length "d": is the distance between point P and point P' measured in projection view on the plane of symmetry X parallel to the reference axes x and z;
- length "I": is the distance between point P and its symmetrical point relative to plane Y measured in projection view on the plane of symmetry X; "I/2" is thus the distance between point P and point P' - maximum point of concavity - measured in projection view on the plane of symmetry X;

- height "h": is the distance between point P and point P' measured in projection view on the plane of symmetry Y;
- height "f": is the distance between point P' and point P" measured in projection view on the plane of symmetry Y; such value is also called camber or lateral semi-extension.

According to the invention, the ingot mold advantageously has the following values at the entrance section:
- I is between 750 and 1500 mm
- f is between 15 and 100 mm

Furthermore, in the entrance section, again, ratio d/l and ratio h/f are between 10% and 60%.

A first advantageous variation of the ingot mold, according to the present invention, includes a casting chamber 3 with an entrance section of the steel larger than an exit section. In particular, the radius of curvature of the concave area 11, when in the shape of a semi-circular arc, has a linearly increasing value - on the cross-sectional plane - between the entrance section and an intermediate section, which corresponds to the terminal section of the casting chamber before the exit section of the steel; instead, the radius of curvature of the connecting zones S has a linearly decreasing value between the entrance section and said intermediate section.

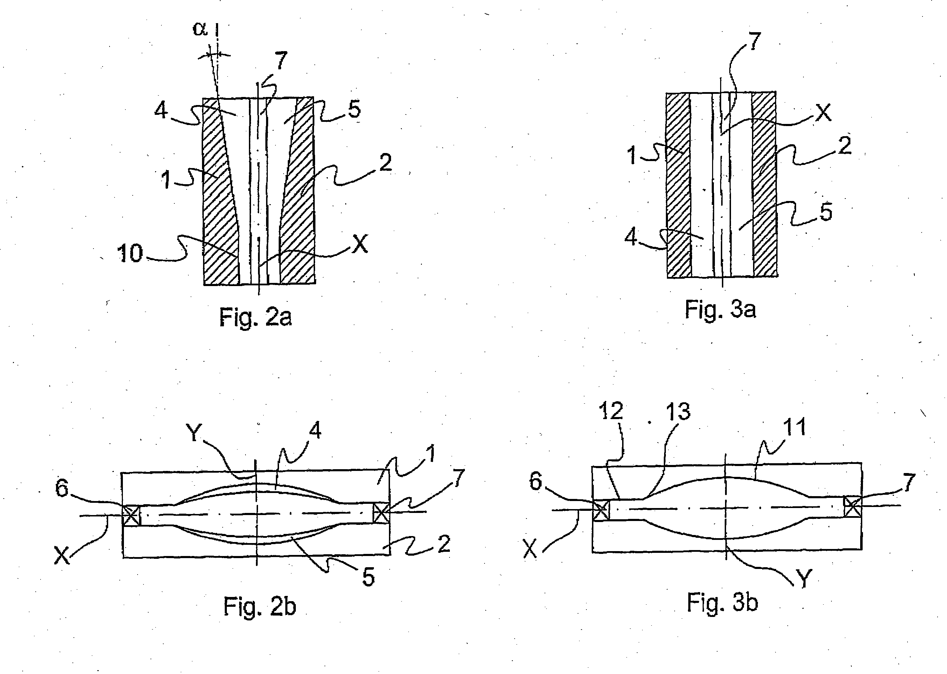

In this case, such cavity or casting chamber 3 will longitudinally pass through generating lines converging towards the exit as far as the intermediate section. As a result, in the section described in Fig. 2a, there is a decrease in width with a conical trend.

In this case, the value of the camber f in the entrance section of the ingot mold has a maximum value and a minimum value at the exit section of the basin.

Advantageously, the ingot mold of this invention includes an inclination of the walls of said chamber, converging towards said intermediate section, determined by an angle a (from 0° - 7°) wherein said angle a is measured as an inclination relative to plane X, and in projection view, on the plane of symmetry Y.

This particular configuration of the casting chamber also allows the molten steel to skim the flat-faced side zones 12 as far as the corners, thus preventing the complete solidification of the slab in such zones although the distance between said faces is shorter than that known in the art.

The bottom end of the ingot mold includes a final portion 10 with a parallel-generating line, the length of which is predetermined and is structurally identical to said intermediate section to allow the removal of the shaped head of the dummy bar in order to start the continuous casting process.

Moreover, the smaller inclination angle of the wide walls 4, 5 of the casting chamber determined by the angle α prevents the unwanted remelting phenomenon of the formed skin inasmuch as the molten steel introduced in the chamber by the discharge device does not cause turbulences in the feeding zones of the ingot mold near the walls, thereby ensuring an optimal flow of the discharged steel.

The narrow walls 6, 7, preferably flat and rectangular, in a preferred variation of the invention, are advantageously moveable and capable of moving toward or away from each other, thereby allowing the width adjustment of the slab. Additionally, they can change their tapering shape. More precisely, they can be tilted towards the exit section of the steel so as to reduce the width of the exit section, thus avoiding shrinkage problems during the solidification in the ingot mold.

It is possible to cast ultra thin slabs at high casting speeds through the ingot mold or crystallizer of the invention. all this is performed without creating excessive deformations, hence cracks, on the slab skin which moves along the walls of the crystallizer. Of particular relevance is the fact that the internal structure of such ingot mold ensures a suitable volume of molten steel, thus when the slab comes out, there will still be a certain length of the liquid core. This particular shape maintains the liquid core even when very close to the furthermost sides of the slab, thereby making a subsequent liquid core pre-rolling possible, the so-called "soft reduction", for the cast slab. Advantageously, the presence of molten steel in the side zones, - hence the fact that in such limited zones the complete solidification has not occurred - will prevent unwanted cracks and ensure an effective melting of the lubrication powders.

Conversely, a second variation of the ingot mold according to the invention includes entrance and exit sections of equal dimensions, as described in the section in Fig. 3a. In this case, the radii of curvature maintain the same value in each point of the longitudinal extension of the casting chamber between the entrance section and the exit section of the steel. In this variation, the aforesaid intermediate section coincides with the exit section of the steel.

The casting of very thin slabs, through the ingot mold of the invention, allows for the possibility to create a starting product, i.e. the slab thereof, with a thickness which is already very close to that of the finished product, namely the strip. Advantageously, the thickness of these thin slabs, when exiting, is between 20 and 50 mm and their casting speed is between 6 and 16 m/min.

The typical convex shape of the slab, in other words the central swelling at the exit of the ingot mold, is cancelled, that is flattened, through the use of rolls placed at the foot of the ingot mold and appropriately shaped, thus performing the liquid core pre-rolling.

This allows for a considerable reduction of the number of machines used in the system/process, which means saving possibilities in terms of first investment and energy.

## Claims

1. Ingot mold for casting ultra thin (20 - 50 mm) steel slabs, with casting speed between 6 and 16 m/min, thus defining a longitudinal plane of symmetry (X) and a cross-sectional plane of symmetry (Y), reciprocally orthogonal, comprising a through cavity with an entrance section and an exit section of the steel, the cavity surface consisting of two first walls (4, 5) arranged reciprocally facing two opposite sides of the longitudinal plane of symmetry (X) and two second narrow, flat, rectangular walls (6, 7) located parallel to the cross-sectional plane of symmetry (Y) , wherein the first and second walls form four longitudinal corners in the reciprocal connecting areas,
wherein the first walls (4, 5) have a concave central zone (11), with concavity facing the longitudinal plane of symmetry (X), portions of wall (R) rectilinear to its ends and intermediate convex connecting portions (S), with convexity facing the longitudinal plane of symmetry (X), in which the connecting portions (S) and the concave central zone (11) determine inflection points (P') in the reciprocal connecting points and where the straight portions of wall (R) as well as the connecting portions (S) determine connecting points (P) in the reciprocal junction points **characterized in that** the ratio between the length d/I is between 10 and 60% and the ratio h/f is between 10% and 60% wherein:
- "d" is the length of the connecting portion (S) measured in projection view on the longitudinal plane of symmetry (X),
- length "I" is the distance between the two symmetrical connecting points relative to the cross-sectional plane of symmetry (Y), measured in projection view on the plane of symmetry (X),
- "h": is the distance between the connecting point P and the inflection point P' measured in projection view on the cross-sectional plane of symmetry Y;
- "f" is the distance between point P' and the tangent to the concave zone in the maximum point of concavity measured in projection view on the plane of symmetry Y.

2. Ingot mold according to claim 1 wherein the concave zone (11) - within its sections and on planes perpendicular to the longitudinal and cross-sectional planes of symmetry (X) - is in the shape of a semi-circular arc with radii of curvature having a linearly increasing value between the entrance section and a predetermined intermediate section located before the exit section of the steel.

3. Ingot mold according to claim 2, wherein a variation of the radii of curvature in the various sections of the concave zone (11) is such as to determine an inclination (α) of the first walls (4, 5) relative to the longitudinal plane of symmetry (X), the value of which is between 0°and 7°.

4. Ingot mold according to claim 1 wherein the radii of curvature of the concave central zone (11) have the same value in each point of the longitudinal extension between the entrance section and the exit section.

5. Ingot mold according to one or more of the previous claims wherein "I" has a value between 750 and 1500 mm and "f" is between 15 and 100 mm at the entrance section.

6. Ingot mold according to one or more of the previous claims wherein the second walls (6, 7) can be tilted and reciprocally moved toward or way from each other at the exit section.

## Patentansprüche

1. Block-Kokille zum Gießen ultra-dünner (20 bis 50 mm) Stahl-Platten mit einer Gieß-Geschwindigkeit zwischen 6 und 16 m/min, um damit eine Längs-Symmetrieebene (X) und eine Querschnitts-Symmetrieebene (Y) zu definieren, die wechselseitig orthogonal sind, umfassend eine durchgehende Höhlung mit einem Einlauf-Abschnitt und einem Auslauf-Abschnitt des Stahls, wobei die Höhlungs-Oberfläche besteht aus zwei ersten Wänden (4, 5), die so angeordnet sind, dass sie wechselseitig zwei gegenüberliegenden Seiten der Längs-Symmetrieebene (X) gegenüber liegen, und aus zwei zweiten schmalen, flachen, rechteckigen Wänden (6, 7), die parallel zu der Querschnitts-Symmetrieebene (Y) angeordnet sind, wobei die ersten und zweiten Wände vier Längs-Ecken in den wechselseitigen Verbindungs-Bereichen bilden,
worin die ersten Wände (4, 5) aufweisen: eine konkave zentrale Zone (11), wobei die Wölbung der Längs-Symmetrieebene (X) gegenüberliegt, Wand-Teile (R), die geradlinig zu ihren Enden sind, und konvexe Zwischen-Verbindungs-Teile (S), wobei die Wölbung der Längs-Symmetrieebene (X) gegenüberliegt, worin die Verbindungs-Teile (S) und die konkave zentrale Zone (11) Wendepunkte (P') in den wechselseitigen Verbindungs-Punkten bestimmen und worin die geraden Teile der Wand (R) sowie die verbindenden Teile (S) Verbindungs-Punkte (P) in den wechselseitigen Knotenpunkten bestimmen, **dadurch gekennzeichnet, dass** das Verhältnis zwischen der Länge d/l zwischen 10 und 60 % liegt und das Verhältnis h/f zwischen 10 % und 60 % liegt, worin:
- "d" die Länge des verbindenden Teils (S) ist, gemessen in Projektions-Sicht auf die Längs-Symmetrieebene (X);
- die Länge "1" die Entfernung zwischen den beiden symmetrischen Verbindungspunkten bezogen auf die Querschnitts-Symmetrieebene (Y) ist, gemessen in Projektions-Sicht auf die Symmetrieebene (X);
- "h" die Entfernung zwischen dem Verbindungs-Punkt P und dem Wendepunkt P' ist, gemessen in Projektions-Sicht auf die Querschnitts-Symmetrieebene Y;
- "f" die Entfernung zwischen dem Punkt P' und dem Tangens zu der konkaven Zone in dem Maximum-Punkt der Wölbung ist, gemessen in Projektions-Sicht auf die Symmetrieebene Y.

2. Block-Kokille nach Anspruch 1, worin die konkave Zone (11) innerhalb ihrer Abschnitte und auf Ebenen senkrecht zu den Längs- und Querschnitts-Symmetrieebenen (X) in der Form eines Halbkreis-Bogens mit Krümmungsradien vorliegt, die einen linear ansteigenden Wert zwischen dem Einlauf-Abschnitt und einem vorbestimmten Zwischen-Abschnitt aufweisen, der vor dem Auslauf-Abschnitt des Stahls angeordnet ist.

3. Block-Kokille nach Anspruch 2, worin eine Schwankung der Krümmungsradien in den verschiedenen Abschnitten der konkaven Zone (11) derart ist, dass man eine Neigung (α) der ersten Wände (4, 5) relativ zu der Längs-Symmetrieebene (X) bestimmt, deren Wert zwischen 0° und 7° liegt.

4. Block-Kokille nach Anspruch 1, worin die Krümmungsradien der konkaven zentralen Zone (11) denselben Wert in jedem Punkt der Längs-Erstreckung zwischen dem Einlauf-Abschnitt und dem Auslauf-Abschnitt haben.

5. Block-Kokille nach einem oder mehreren der vorangehenden Ansprüche, worin "1" einen Wert zwischen 750 und 1500 mm hat und "f" zwischen 15 und 100 mm an dem Einlauf-Abschnitt liegt.

6. Block-Kokille nach einem oder mehreren der vorangehenden Ansprüche, worin die zweiten Wände (6, 7) an dem Auslauf-Abschnitt gekippt und wechselseitig aufeinander zu oder voneinander weg bewegt werden können.

## Revendications

1. Lingotière pour la coulée de brames en acier ultraminces (20 - 50 mm), à une vitesse de coulée entre 6 et 16 m/min, en définissant ainsi un plan longitudinal de symétrie (X) et un plan en section verticale de symétrie (Y), réciproquement orthogonaux, comprenant une cavité traversante avec une section d'entrée et une section de sortie de l'acier, la surface de la cavité consistant en deux premières parois (4, 5) agencées réciproquement de façon à faire face à deux côtés opposés du plan longitudinal de symétrie (X) et deux deuxièmes parois rectangulaires étroites, plates (6, 7) situées parallèlement au plan en section transversale de symétrie (Y), où les premières et deuxièmes parois forment quatre coins longitudinaux dans les zones de connexion réciproques,
où les première parois (4, 5) ont une zone centrale concave (11), la concavité faisant face au plan longitudinal de symétrie (X), des portions de paroi (R) rectilignes vers leurs extrémités et des portions de connexion convexes intermédiaires (S), la convexité faisant face au plan longitudinal de symétrie (X), où les portions de connexion (S) et la zone centrale concave (11) déterminent des points d'inflexion (P') dans les points de connexion réciproques, et où les portions de paroi droites (R) ainsi que les portions de connexion (S) déterminent des points de connexion (P) dans les points de jonction réciproques,
**caractérisée en ce que** le rapport entre la longueur d/l est entre 10 et 60 % et le rapport h/f est entre 10 % et 60 %,
où :
- "d" est la longueur de la portion de connexion (S) mesurée en une vue en projection sur le plan longitudinal de symétrie (X),
- la longueur "1" est la distance entre les deux points de connexion symétriques relativement au plan en section transversale de symétrie (Y), mesurée en une vue en projection sur le plan de symétrie (X),
- "h" est la distance entre le point de connexion P et le point d'inflexion P' mesurée en une vue en projection sur le plan en section transversale de symétrie Y ;
- "f" est la distance entre le point P' et la tangente à la zone concave dans le point de concavité maximum mesurée en une vue en projection sur le plan de symétrie Y.

2. Lingotière selon la revendication 1, dans laquelle la zone concave (11) - dans ses sections et sur des plans perpendiculaires aux plans longitudinal et en section transversale de symétrie (X) - est dans la forme d'un arc semi-circulaire, les rayons de courbure ayant une valeur qui augmente linéairement entre la section d'entrée et une section intermédiaire prédéterminée située devant la section de sortie de l'acier.

3. Lingotière selon la revendication 2, dans laquelle une variation des rayons de courbure dans les diverses sections de la zone concave (11) est conçu pour déterminer une inclinaison (a) des premières parois (4, 5) relativement au plan longitudinal de symétrie (X), dont la valeur est entre 0° et 7°.

4. Lingotière selon la revendication 1, dans laquelle les rayons de courbure de la zone centrale concave (11) ont la même valeur dans chaque point de l'extension longitudinal entre la section d'entrée et la section de sortie.

5. Lingotière selon l'une ou plusieurs des revendications précédentes, dans laquelle "1" a une valeur entre 750 et 1500 mm, et "f" est entre 15 et 100 mm à la section d'entrée.

6. Lingotière selon l'une ou plusieurs des revendications précédentes, dans laquelle les secondes parois (6, 7) peuvent être amenées à basculer et peuvent être déplacées réciproquement vers ou au loin l'une de l'autre à la section de sortie.
